# EUROPÄISCHE PATENTSCHRIFT

(11) **EP 0 625 832 B1**
(45) Veröffentlichungstag und Bekanntmachung des Hinweises auf die Patenterteilung: **14.10.1998**
(21) Anmeldenummer: 94106791.0
(22) Anmeldetag: 30.04.1994
(51) Int. Cl.: H04B 1/59, G07C 11/00, G01S 13/75

(54) **Lesegerät für ein Detektierplättchen**
Reading device for a detection label
Dispositif de lecture pour un détecteur en forme de carte

(30) Priorität: 17.05.1993 DE 4316468; 17.08.1993 DE 4327642
(43) Veröffentlichungstag der Anmeldung: 23.11.1994
(73) Patentinhaber: Stobbe, Anatoli, 30890 Barsinghausen (DE)
(72) Erfinder: Stobbe, Anatoli, 30890 Barsinghausen (DE)
(74) Vertreter: Patentanwälte Thömen & Körner

(56) Entgegenhaltungen:
- EP-A- 0 446 735
- DE-A- 4 003 410
- GB-A- 2 255 692

## Beschreibung

Die Erfindung betrifft ein Lesegerät für ein Detektierplättchen, gemäß dem Oberbegriff des Patentanspruchs 1.

Lesegeräte dieser Art sind bereits durch die deutschen Patente DE 40 03 410 C2 und DE 41 34 922 C1 bekannt. Sie sind geeignet, Detektierplättchen der in dem deutschen Patent DE 40 03 410 C2 beschriebenen Art berührungslos zu lesen und zu programmieren.

Das Anwendungsgebiet dieser Lesegeräte liegt in Verbindung mit den Detektierplättchen bei der Technik zur berührungslosen Identifizierung von Menschen, Fahrzeugen, Gütern und weiteren Gegenständen. Diese Technik kommt in letzter Zeit verstärkt zum Einsatz. Je nach Anwendungsfall werden dabei Detektierplättchen an Menschen, Fahrzeugen und Gütern usw. befestigt und meistens von stationären Lesegeräten erfaßt.

Häufig tragen die betreffenden Personen das Detektierplättchen am Schlüsselbund oder in der Hosentasche oder auch in der Brusttasche, wenn das Detektiertplättchen die Form einer Kreditkarte besitzt.

Die Lesegeräte, die den Detektierplättchen zugeordnet sind, besitzen eine Antenne, welche als Sende-Empfangs-Antenne dient, und eine entweder von der Antenne abgesetzte oder auch mit ihr integrierte Auswerteeinheit. Diese dient unter anderem zur Auswertung der von dem Detektierplättchen empfangenen Daten.

Das Detektierplättchen besitzt keine eigene Batterie für die Energieversorgung. Es bezieht seine Energie vielmehr von der Energie, die von dem Lesegerät über die Antenne zum Detektierplättchen übertragen wird. Die Datenübertragung vom Detektierplättchen zum Lesegerät wird ebenfalls über die Antenne mittels einer Absorbtionsmodulation durchgeführt.

Trotz der fehlenden eigenen Energieversorgung des Detektierplättchens besteht bei den berührungslos arbeitenden Systemem der Wunsch, möglichst große Reichweiten bzw. Abstände zwischen dem Lesegerät und dem Detektierplättchen zu ermöglichen. Je größer sich der Abstand realisieren läßt, um so bequemer kann man nämlich eine Lesestelle, also ein Lesegerät, zum Zwecke einer Identifikation passieren, ohne daß es beispielsweise erforderlich ist, die Brieftasche oder das Schlüsselbund, also ganz allgemein denjenigen Gegenstand, der das Detektierplättchen beinhaltet, aus der Kleidung herausholen zu müssen und in die Nähe des Lesegerätes bringen zu müssen.

In der Praxis ist es so, daß die berührungslosen Lesesysteme meistens von Elektroinstallateuren montiert werden. Häufig wird bei der stationären Anbringung des Lesegerätes die Antenne noch vor den abschließenden Putzarbeiten auf der Baustelle an einer vorgegebenen Lesestelle in der gewünschten Wand des betreffenden Gebäudes installiert. Erst nach Abschluß aller anderen Bauarbeiten werden dann die anderen Komponenten, nämlich die weiteren Bestandteile des Lesegerätes und die Detektierplättchen ergänzt und das komplette System wird in Betrieb genommen.

Es hat sich gezeigt, daß bei der Inbetriebnahme immer wieder Probleme auftreten. Der zur Antenne gehörende Antennenschwingkreis besteht aus einer als Spule ausgebildeten Induktivität sowie aus einer durch einen Kondensator gebildeten Kapazität. Wenn nun ein solcher Antennenschwingkreis z. B. in Form einer Rahmenantenne an bzw. in einer Wand angeordnet ist, wird der Antennenschwingkreis durch die Kapazität der Wand verstimmt. Somit ist der Antennenschwingkreis nicht mehr auf die vorgegebene Resonanzfrequenz abgestimmt.

Je nach der Beschaffenheit der Wand ist die Kapazität der Wand und damit auch die Verstimmung des Antennenschwingkreises unterschiedlich groß. Diese Problematik gilt auch für Antennen, die in einer Fahrbahn oder Straße verlegt werden. Hier sind äußere Einflüsse wie Feuchtigkeit, Eis, Schnee oder auch die generellen Bodenbeschaffenheiten dafür verantwortlich, daß die Antenne des Lesegerätes verstimmt wird.

Diese möglichen Verstimmungen des Antennenschwingkreises stehen dem Wunsch entgegen, möglichst große Abstände zwischen dem Detektierplättchen und dem Lesegerät bei der Identifikation zu ermöglichen. Wenn nämlich der Antennenschwingkreis des Detektierplättchens und der Antennenschwingkreis des Lesegerätes nicht auf der gleichen Resonanzfrequenz jeweils auf Maximum getrimmt sind, verschlechtern sich die Koppelverhältnisse zwischen den beiden Antennenschwingkreisen. Schon bei einer geringfügigen Verstimmung der Antenne des Lesegerätes nimmt der mögliche Leseabstand beträchtlich ab.

Wenn demgegenüber der Antennenschwingkreis des Lesegerätes so abgestimmt ist, daß er auf der gleichen Resonanzfrequenz wie der Antennenschwingkreis des Detektierplättchens schwingt, ergeben sich aufgrund der Resonanzüberhöhung ideale Koppelverhältnisse, die einen großen Leseabstand zwischen dem Detektierplättchen und dem Lesegerät ermöglichen.

Es ist zwar schon bekannt, die Lesegeräte mit einem Drehkondensator auszustatten, um den Antennenschwingkreis bei einer nach dem Einbau der Antenne eingetretenen Verstimmung zu beeinflussen und an die Bedingungen des Einbauortes anzupassen, um den Antennenschwingkreis also wieder auf die vorgegebene Resonanzfrequenz abzustimmen. Jedoch hat sich in der Praxis die Verwendung solcher Drehkondensatoren nicht bewähren können.

Die Erfahrung zeigt vielmehr, daß der Personenkreis - Installateure oder Servicetechniker - mit den vorzunehmenden Trimmarbeiten überfordert sind. Vielfach sind diesem Personenkreis die technischen Bereiche von Antennen sowie die HF-Technik nur wenig geläufig, was dazu führt, daß dieser Personenkreis die beschriebene Nach-Abstimmung des Antennenschwingkreises mit Hilfe des Drehkondensators meiden. Zum Abstimmen wird nicht nur ein Schraubenzieher benötigt, sondern es müssen auch entsprechende Meßgeräte wie Feldstärkemesser oder Oszillograph mit einer speziellen Empfangsantenne vorhanden sein, die jedoch meistens nicht zur Verfügung stehen. Letztendlich unterbleibt also die erforderliche Abstimmung der eingebauten Antenne, und aus diesen Gründen gibt es daher kaum berührungslose Systeme mit großen Rahmenantennen, welche gewünschte große Leseabstände von bis zu 1 m ermöglichen.

Diesem Nachteil will die Erfindung entgegentreten, der die Aufgabe zugrunde liegt, ein Lesegerät der im Oberbegriff des Patentanspruchs 1 genannten Art zu schaffen, welches große Abstände zwischen dem Lesegerät und dem Detektierplättchen bei der bestimmungsgemäßen Verwendung von Lesegerät und Detektierplättchen ermöglicht.

Die Lösung dieser Aufgabe erfolgt durch die im kennzeichnenden Teil des Patentanspruchs 1 angegebenen Merkmale.

Die Erfindung sieht bei dem Lesegerät eine automatisch arbeitende Abstimmeinheit vor, durch welche der Antennenschwingkreis automatisch auf die vorgegebene Resonanzfrequenz abgestimmt werden kann. Wenn beim Einbau der Antenne beispielsweise in eine Wand aufgrund der Kapazität dieser Wand der ursprünglich auf die Resonanzfrequenz ausgelegte Antennenschwingkreis verstimmt wird, sorgt die Abstimmeinheit dafür, daß der Antennenschwingkreis automatisch wieder auf die Resonanzfrequenz abgestimmt und somit der Einfluß der Kapazität der Wand eliminiert wird. Durch die Erfindung ist daher gewährleistet, daß der Antennenschwingkreis unabhängig von äußeren Einflüssen stets optimal abgestimmt ist, ohne daß hierzu von einer Bedienungsperson noch irgendwelche externen Abstimmarbeiten vorgenommen werden müssen. Da sichergestellt ist, daß die Antennenschwingkreise des Detektierplättchens und des Lesegerätes stets auf der gleichen Resonanzfrequenz schwingen, ergeben sich aufgrund der Resonanzüberhöhung ideale Koppelverhältnisse, die einen maximalen Leseabstand ermöglichen. Nach dem Einbau der Antenne des Lesegerätes sind keinerlei zusätzliche Maßnahmen und Abtrimmarbeiten mehr erforderlich, vielmehr werden diese Abtrimmarbeiten durch die Erfindung automatisiert.

Gemäß einer vorteilhaften Weiterbildung der Erfindung ist vorgesehen, dem Antennenschwingkreis durch die Abstimmeinheit zusätzlich vorgesehene Kapazitäten und/oder Induktivitäten zuzuschalten bzw. die zusätzlich vorgesehenen Kapazitäten und/oder Induktivitäten von dem Antennenschwingkreis abzuschalten. Auf diese Weise lassen sich die Kapazitätswerte und/oder Induktivitätswerte, welche die Resonanzfrequenz bestimmen, einfach variieren, um den Antennenschwingkreis in Abhängigkeit der äußeren Einflüsse automatisch auf die Resonanzfrequenz abzustimmen.

Eine besonders zweckmäßige Ausgestaltung der Erfindung sieht vor, daß die Kapazität des Schwingkreiskondensators des Antennenschwingkreises kleiner bemessen ist, als die der Resonanzfrequenz des Antennenschwingkreises entsprechende Kapazität.

Durch diese Maßnahme ist es möglich, die Antennenschwingkreiskapazität so zu verändern, daß eine Abstimmung des Antennenschwingkreises in beiden Richtungen erfolgen kann. Weiterhin ist es zweckmäßig, die Werte der zusätzlichen Kapazitäten und/oder Induktivitäten im Sinne einer binären Abstufung zu wählen. Auf diese Weise lassen sich beispielsweise mit vier zusätzlichen Kapazitäten insgesamt sechzehn unterschiedliche Kapazitätswerte realisieren.

In vorteilhafter Weise gestattet es die Erfindung, den Mikroprozessor, welcher der Auswerteeinheit des Lesegerätes zugeordnet ist, neben der üblichen Datenauswertung zur automatischen Abstimmung des Antennenschwingkreises heranzuziehen. Daneben ist es auch möglich, einen separaten Abstimm-Mikroprozessor innerhalb der automatischen Abstimmeinheit vorzusehen.

Die Mikroprozessoren lassen sich in zweckmäßiger Ausgestaltung der Erfindung mit einem Algorithmus programmieren, der eine automatische Abstimmung des Antennenschwingkreises auf seine Resonanzfrequenz ermöglicht. Als Algorithmus kann das Auffinden des Maximums der Schwingkreisspannung bzw. des Schwingkreisstromes nach der an sich bekannten Methode der sukzessiven Approximation durchgeführt werden, bei der eine schrittweise Annäherung an das Maximum der Schwinkreis-spannung bzw. des Schwingkreisstromes vorgenommen wird. Die Schwingkreiskapazität wird also schrittweise solange verändert, bis die Schwingkreisspannung bzw. der Schwingkreisstrom das Maximum besitzt.

Gemäß einer weiteren zweckmäßigen Ausgestaltung der Erfindung wird ständig eine automatische Abstimmung des Antennenschwingkreises auf die Resonanzfrequenz durchgeführt.

Dadurch wird erreicht, daß der Antennenschwingkreis stets optimal abgestimmt ist, auch wenn sich im Verlaufe der Zeit die äußeren Einflüsse (z. B. Feuchtigkeit der Wand und damit die Kapazität der Wand) ändern.

Das ständige automatische Abstimmen ist beispielsweise eine wichtige Forderung bei Parkanlagen in Parkhäusern, in denen die Schranke am Ausgang durch ein Detektierplättchen geöffent wird, welches unten am Fahrzeug montiert ist. Das Lesegerät befindet sich dabei in der Fahrbahn bzw. in dem Boden.

In dem beschriebenen Anwendungsfall des berührungslosen Identifikationssystems ist nicht vorhersehbar, welcher Fahrzeugtyp sich jeweils über der Antenne befindet, und je nach Fahrzeugmodell ist ein unterschiedlicher Abstand zwischen dem Detektierplättchen und dem Lesegerät vorhanden. Durch diese unterschiedlichen Abstände wird der Antennenschwingkreis in Folge der großen Eisenmasse des Fahrzeuges stark verstimmt. Deshalb ist es hier von besonderem Vorteil, wenn der separate Mikroprozessor der Abstimmeinheit ständig eine automatische Abstimmung des Antennenschwingkreises auf die Resonanzfrequenz durchführt, damit jedes Fahrzeug zuverlässig identifiziert werden kann.

In weiterer vorteilhafter Ausgestaltung der Erfindung erfolgt die automatische Abstimmung nur innerhalb eines eingeschränkten wählbaren Abstimmbereiches.

Durch diese Maßnahme läßt sich eine Geschwindigkeitserhöhung bei der automatischen Abstimmung erzielen, so daß die Zeitdauer der automatischen Abstimmung auf die Resonanzfrequenz nur gering ist. Dies ist von Interesse bei dem voranstehend beschriebenen Anwendungsfall der Identifizierung von unterschiedlichen Fahrzeugtypen, bei denen unterschiedliche Abstände zwischen dem Detektierplättchen und dem Lesegerät vorhanden sind. Man kann hier einige extrem unterschiedliche Fahrzeugtypen mit unterschiedlichen Abständen über der Fahrbahn durchmessen und danach den Mikroprozessor lediglich zwischen einigen Werten hin- und herschalten, anstatt den vollen Abstimmbereich zu durchlaufen.

Eine andere zweckmäßige Ausgestaltung der Erfindung sieht vor, daß die automatische Abstimmung jeweils nach dem Einschalten der Betriebsspannung des Lesegerätes vorgenommen wird. Daneben kann es aber auch zweckmäßig sein, die automatische Abstimmung durch Betätigung einer gesonderten Taste einzuleiten. Vorteilhaft ist auch die Möglichkeit, die automatische Abstimmung durch ein von dem Detektierplättchen gesendetes spezielles Schaltsignal zu starten.

Besonders zweckmäßig ist es im Rahmen der Erfindung, wenn die automatische Abstimmung in wählbaren Zeitabständen periodisch durchgeführt wird. Diese Maßnahme empfiehlt sich insbesondere dann, wenn aufgrund der örtlichen Gegebenheiten zu erwarten ist, daß sich die äußeren Einflüsse, welche eine Verstimmung des Antennenschwingkreises bewirken, nur über längere Zeiträume hinweg ändern.

Schließlich besteht auch noch die Möglichkeit, die automatische Abstimmung in Abhängigkeit der Qualität der vom Lesegerät empfangenen Signale des Detektierplättchens einzuleiten und zwar dann, wenn die Qualität dieser Signale eine vorgebbare Toleranzgrenze unterschreitet, bzw. wenn die Signalform der Daten schlecht oder unvollständig ist.

Insgesamt wird durch die Erfindung ein Lesegerät bei einem berührungslosen Identifikationssystem geschaffen, welches es ermöglicht, große Abstände zwischen dem Lesegerät und dem Detektierplättchen vorzusehen, ohne daß dadurch der sichere Funktionsablauf gefährdet wird.

Nachfolgend wird die Erfindung anhand der in der Zeichnung dargestellten Ausführungsbeispiele näher erläutert. Es zeigen:
- Fig. 1: eine schematische Darstellung eines berührungslosen Identifikationssystems mit einem Lesegerät und einen Detektierplättchen,
- Fig. 2: eine etwas detalliertere Darstellung eines Detektierplättchens und eines Lesegerätes gemäß Fig. 1,
- Fig. 3: eine schematische Darstellung einer an einer Wand angeordneten Rahmenantenne eines Lesegerätes,
- Fig. 4: ein elektrisches Schaltbild eines Antennenschwingkreises des Lesegerätes zur Verdeutlichung der Kapazität der in Fig. 3 gezeigten Wand,
- Fig. 5: ein schematisches Schaltbild eines Lesegerätes mit einer automatischen Abstimmeinheit,
- Fig. 6: ein schematisches Schaltbild der automatischen Abstimmung eines Antennenschwingkreises, und
- Fig. 7: eine Darstellung des Verlaufes der Schwingkreisspannung in Abhängigkeit der Schwingkreiskapazität.

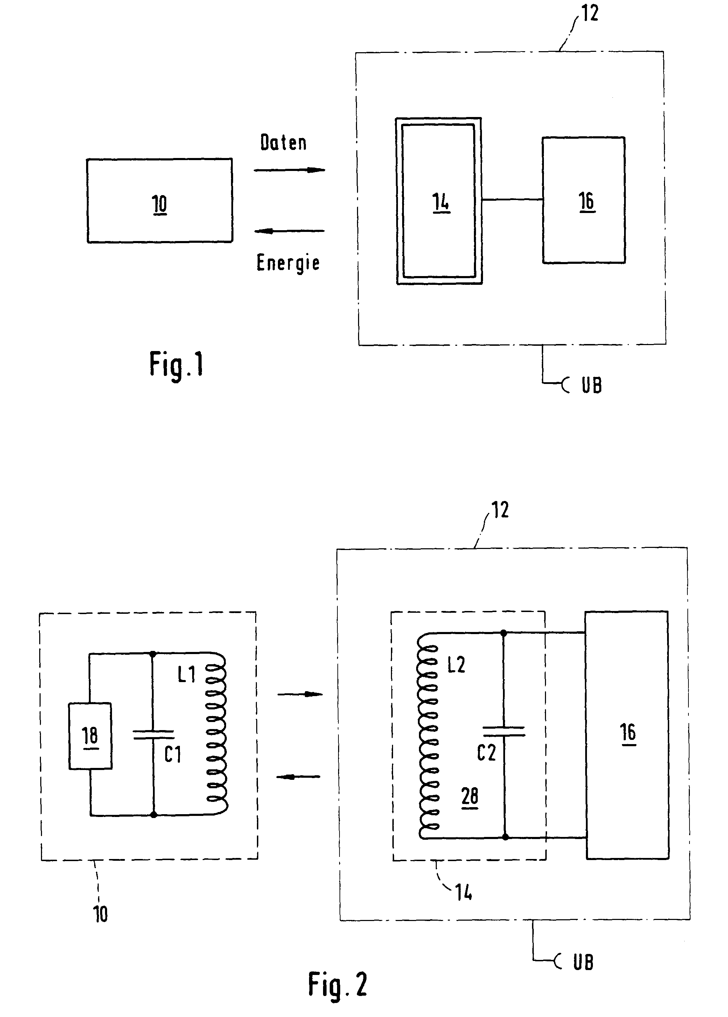

In Fig. 1 und 2 ist in schematischer Form ein berührungsloses Identifikationssystem dargestellt, welches jeweils ein bekanntes Detektierplättchen 10 sowie ein bekanntes Lesegerät 12 umfaßt. Zwischen dem Detektierplättchen 10 und dem Lesegerät 12 findet ein Datenaustausch statt. Da das Detektierplättchen 10 über keine eigene Batterie verfügt, erfolgt außerdem von dem Lesegerät 12 eine Energieübertragung zum Detektierplättchen 10.

Der bekannte Aufbau des Detektierplättchens 10 umfaßt einen Chip 18 sowie einen durch eine Kapazität C1 und durch eine Induktivität L1 gebildeten Schwingkreis als Antenne. Dieser Schwingkreis ist auf die Resonanzfrequenz fo abgestimmt.

Das Lesegerät 12 wird mit einer Betriebsspannung UB gespeist und besitzt in bekannter Weise eine Rahmenantenne 14, die als Sende-Empfangs-Antenne arbeitet, sowie eine Auswerteeinheit 16. Die Rahmenantenne bildet eine Induktivität L2, die zusammen mit einer Kapazität C2 den Antennenschwingkreis darstellt.

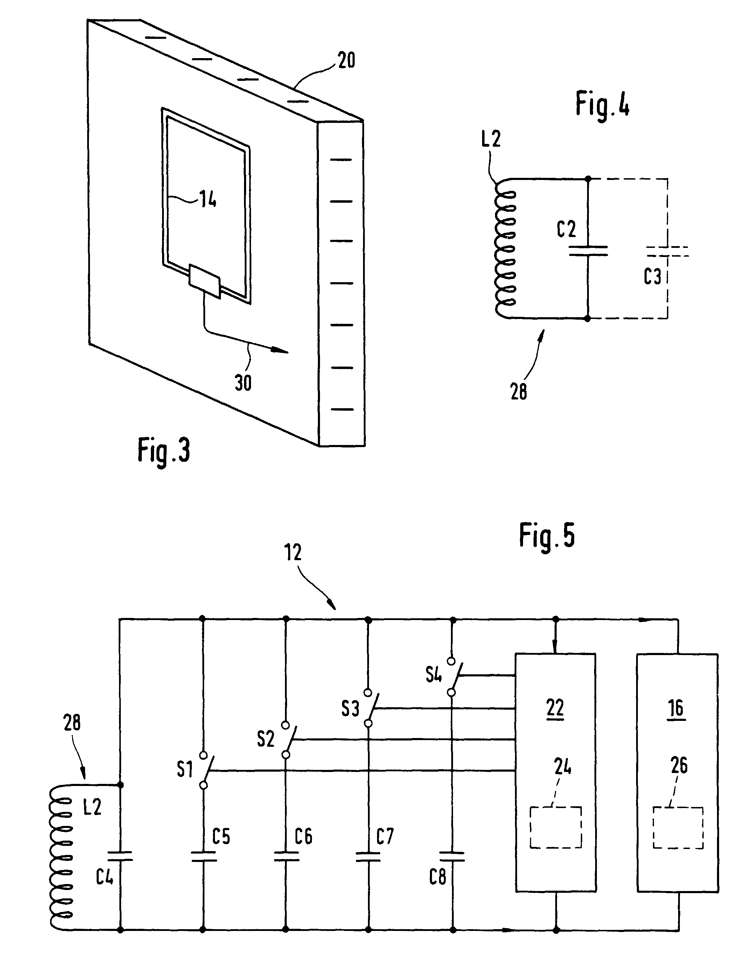

Die Darstellung in Fig. 3 zeigt eine Rahmenantenne 14 des Lesegerätes 12, wobei die Rahmenantenne 14 auf oder in einer Wand 20 angeordnet und über eine elektrische Leitung 30 mit der hier nicht gezeigten Auswerteeinheit 16 verbunden ist. In Fig. 4 ist durch den gestrichelt gezeichneten Kondensator die Kapazität C3 der Wand 20 verdeutlicht. Durch diese Kapazität C3 wird der Antennenschwingkreis aus L2 und C2 verstimmt, der somit nicht mehr die Resonanzfrequenz fo besitzt. Diese Verstimmung des Antennenschwingkreises 28 führt dazu, daß sich das Detektierplättchen 10 in sehr geringem Abstand zum Lesegerät 12 bzw. zur Rahmenantenne 14 befinden muß, um eine sichere Arbeitsweise zu gewährleisten.

Fig. 5 zeigt in schematischer Darstellung ein Lesegerät 12 mit einer automatischen Abstimmeinheit 22 zum automatischen Abstimmen des Antennenschwingkreises 28 auf die Resonanzfrequenz fo. Der Antennenschwingkreis 28 umfaßt die Induktivität L2 sowie eine Kapazität C4. Der Wert der Kapazität C4 ist kleiner bemessen, als der Wert, der bei der Induktivität L2 für die Resonanzfrequenz fo erforderlich ist. Parallel zu der den Schwingkreiskondensator C4 bildenden Kapazität sind zusätzliche Kondensatoren C5 - C8 vorgesehen, die über elektronische Schalter S1 - S4 einzeln oder auch mehrfach zugeschaltet bzw. abgeschaltet werden können. Die elektronischen Schalter S1 - S4 lassen sich dabei durch Feldeffekttransistoren realisieren.

Durch die damit ermöglichten Änderungen der Kapazitätswerte kann der Antennenschwingkreis 28 so abgestimmt werden, daß er auf der Resonanzfrequenz fo bzw. zumindest in unmittelbarer Nähe dieser Resonanzfrequenz fo schwingt. Die Veränderung und Einstellung der insgesamt für den Antennenschwingkreis 28 wirksamen Gesamtkapazität wird durch einen separaten Mikroprozessor 24 der automatischen Abstimmeinheit 22 vorgenommen. Zu diesem Zweck kann der Mikroprozessor 24 mit einem Alogrithmus programmiert werden, welcher eine Abstimmung des Antennenschwingkreises auf das Maximum bzw. auf die Resonanzfrequenz fo durch entsprechende Ansteuerung und Betätigung der elektronischen Schalter S1 - S4 erlaubt. Der Algorithmus läßt sich einfach realisieren, nachdem die Resonanzfrequenz fo vorgegeben und die Kapazitätswerte der zusätzlichen Kondensatoren C5 - C8 bekannt sind, und nachdem die Spannung am Antennenschwingkreis 28 bei Speisung mit der Resonanzfrequenz fo gemessen und ausgewertet werden kann.

Die in Fig. 5 gezeigte Kapazität C4 ist in ihrem Wert kleiner bemessen, als es für die Resonanzfrequenz fo erforderlich ist. Somit kann der Antennenschwingkreis 28 in Fig. 5 in beide Richtungen abgestimmt werden, in Abhängigkeit davon, ob die tatsächliche durch die Induktivität L2 und die Kapazität C4 bestimmte Resonanzfrequenz oberhalb oder unterhalb der vorgegebenen Resonanzfrequenz fo liegt.

Die Werte der zusätzlichen Kondensatoren C5 - C8 sind im Sinne einer binären Abstufung gewählt, so daß sich mit den vier Kondensatoren C5 - C8 insgesamt sechzehn verschiedene Kapazitätswerte realisieren lassen. Es sei angenommen, daß der Antennenschwingkreis 28 ursprünglich in Luft (vor dem Einbau der Rahmenantenne 14 in die Wand 20) auf die Resonanzfrequenz fo abgestimmt wurde und daß dabei die Kapazität C2 (vgl. Fig. 2) einen Wert von 1000 pf besitzt. Bei dem in Fig. 5 dargestellten Lesegerät ist der Schwingkreiskondensator C4 dann mit einem kleineren Wert von 850 pf gewählt.

Mit Hilfe der zusätzlichen Kondensatoren C5 - C8 kann die wirksame Kapazität des Antennenschwingkreises 28 nun zwischen 850 pf und 1150 pf verändert werden. Dies entspricht einem Abstimmbereich von 1000 pf +/- 150 pf, bei einer Auflösung von 20 pf. Falls diese Stufen von 20 pf nicht ausreichen oder wenn die Rasterung zu groß ist, können weitere binäre Stufen hinzugefügt oder generell die einzelnen Werte der Stufen verändert werden, so daß eine universelle Anpassung an unterschiedliche Bedingungen möglich ist. Insbesondere läßt sich auch die Anzahl der zusätzlichen Kondensatoren C5 - C8 verändern.

Bei der vorangehenden Beschreibung des Ausführungsbeispiels gemäß Fig. 5 wurde davon ausgegangen, daß der Mikroprozessor 24 der automatischen Abstimmeinheit 22 für die automatische Abstimmung herangezogen wird. Im Rahmen der Erfindung ist es aber auch möglich, den Mikroprozessor 26, welcher Bestandteil des Lesers 12 bzw. der Auswerteeinheit 16 ist, für die automatische Abstimmung mit auszunutzen. So kann eine automatische Abstimmung des Antennenschwingkreies 28 beispielsweise eingeleitet werden, wenn das Lesegerät 12 in Betrieb genommen und an die Betriebsspannung UB angeschaltet und der Mikroprozessor 26 noch nicht für die eigentliche Datenverarbeitung der vom Detektierplättchen 10 empfangenen Daten benötigt wird.

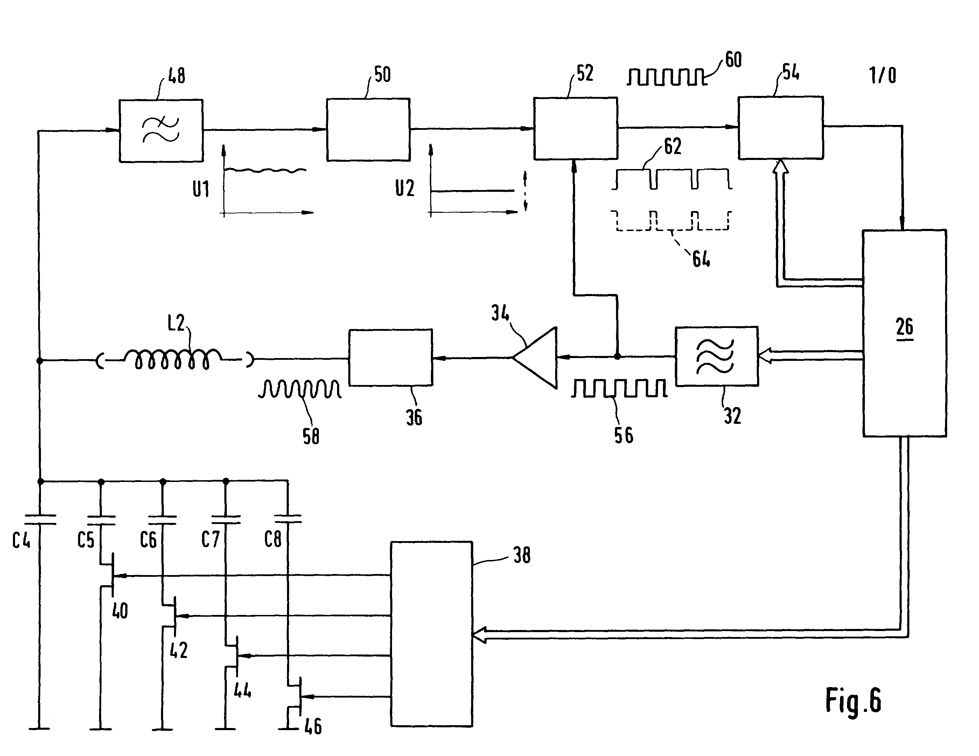

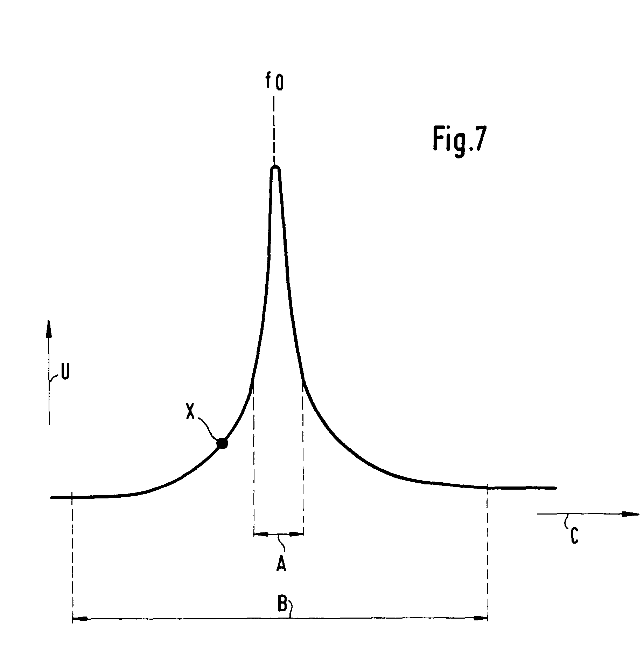

Unter Bezugnahme auf Fig. 6 und 7 wird nachfolgend ein Beispiel einer automatischen Abstimmung näher erläutert. Fig. 6 zeigt hierzu ein schematisches Blockschaltbild, und in Fig. 7 ist in Form einer Resonanzkurve die Schwingkreisspannung U bei sich ändernder Schwingkreiskapazität C dargestellt. Dort sind zwei unterschiedliche Schrittweiten gezeigt. Die Schrittweite A gibt einen Abstimmungsbereich mit 16 Schritten wieder, wie dies der Verwendung der vier schaltbaren zusätzlichen Kondensatoren C5 - C8 entspricht. Die andere Schrittweite B gibt einen größeren Abstimmbereich mit insgesamt 128 Schritten wieder (in diesem Fall werden sieben zusätzliche Kondensatoren erforderlich).

In Fig. 6 erzeugt ein Oszillator 32 Impulse 56 mit der Resonanzfrequenz fo. Diese Impulse 56 gelangen über einen HF-Verstärker 34 zu einem Filter 36 (Pi-Filter), an dessen Ausgang eine Sinusspannung 58 mit der Resonanzfrequenz fo auftritt, welche die Antennenspule L2 speist.

Die an dem Antennenschwigkreis auftretende Schwingkreisspannung U wird einem Tiefpaß 48 mit einem Gleichrichter zugeführt, so daß sich am Ausgang des Tiefpasses 48 die dargestellte gleichgerichtete Spannung U1 einstellt, die noch eine geringe Welligkeit besitzt. Über einen Differenzierer 50 wird die Spannung U1 verarbeitet, wobei sich dann die von dem Hochspannungsanteil befreite differenzierte Gleichspannung U2 ergibt, die einem Amplituden-Komparator 52 zugeführt wird, der auch von dem Oszillator 32 gespeist wird.

An den Amplituden-Komparator 52 schließt sich ein Impulsfilter 54 an, dessen Ausgang entweder das digitale Signal "1" oder "0" besitzt, und diese digitalen Signale werden zum Mikroprozessor 26 geführt. Dieser speist wiederum den Amplituden-Komparator 52, den Oszillator 32 sowie eine Schaltersteuerung 38. Die Schaltersteuerung 38 übernimmt die Ansteuerung von vier Feldeffekttransistoren 40, 42, 44 und 46 zum An- bzw. Abschalten der vier zusätzlichen Kondensatoren C5 - C8.

Wie Fig. 7 zeigt, ändert sich die Schwingkreisspannung U in Abhängigkeit der Schwingkreiskapazität C, wobei die Schwingkreisspannung U bei der Resonanzfrequenz fo bzw. dem dazugehörigen Kapazitätswert C ihr Maximum erreicht. Somit kann durch Ermittlung des Maximums der Schwingkreisspannung die Kapazität C ermittelt bzw. durch Schalten der zusätzlichen Kondensatoren C5 - C8 eingestellt werden.

Die in diesem Sinne durchgeführte automatische Abstimmung kann durch Maximumsuche z. B. nach der an sich bekannten Methode der sukzessiven Approximation, also im Sinne einer schrittweisen Annäherung vorgenommem werden. Es sei beispielsweise angenommen, daß die Schwingkreiskapazität C so klein ist, daß man sich bei der Resonanzkurve in Fig. 7 an dem Punkt X befindet. Durch Verändern der Schwingkreiskapazität C läßt sich dann feststellen, daß sich bei Vergrößerung der Schwingkreiskapazität C auch eine Vergrößerung der Schwingkreisspannung U ergibt, daß man sich also innerhalb des ansteigenden Kurventeils der Resonanzkurve mit positiver Steigung befindet.

In dem angenommenen Fall der positiven Steigung der Resonanzkurve und der Vergrößerung der Werte der Schwingkreiskapazität C ergibt sich am Ausgang des Differenzierers 50 ein Anstieg der Gleichspannung U2, und am Ausgang des Amplituden-Komparators 52 nimmt die ursprüngliche Signalspannung 60 einen Verlauf gemäß der Signalspannung 62 an. Die Signalspannung 62 besteht also zum größten Teil aus "1"-Signalen.

Die Signalspannung 62 wird vom Impulsfilter 54 verarbeitet, welches Impulse unterhalb einer wählbaren Impulsdauer unterdrückt. Dies führt dazu, daß am Ausgang des Impulsfilters 54 das digitale Signal "1" auftritt, welches also angibt, daß die Schwingkreisspannung U bei zunehmenden Kapazitätswerten der Schwingkreiskapazität C ansteigt.

Wenn bei weiter zunehmender Schwingkreiskapazität C das Maximum der Schwingkreisspannung U bei der Resonanzfrequenz fo überschritten und demzufolge die Schwingkreisspannung U wieder abnimmt und man sich im rechten Teil der Resonanzkurve in Fig. 7 mit negativer Steigung befindet, nimmt auch die Gleichspannung U2 ab und am Ausgang des Amplituden-Komparators 52 stellt sich die gestrichelt gezeichnete Signalspannung 64 ein. Am Ausgang des Impulsfilters 54 tritt dann das digitale Signal "0" auf.

In der beschriebenen Weise läßt sich also mit der automatischen Abstimmung mit Hilfe der schaltbaren zusätzlichen Schwingkreiskondensatoren C5 - C8 das Maximum der Schwingkreisspannung U ermitteln und die dazugehörige gewünschte Schwingkreiskapazität C automatisch einstellen. Die dazugehörige Resonanzkurve gemäß Fig. 7 wurde von einem Plotter aufgezeichnet, und zwar bei Anwendung der Schaltungsanordnung gemäß Fig. 6.

Die Erfindung läßt sich selbstverständlich auch bei solchen Lesegeräten anwenden, die nicht nur die vom Detektierplättchen gesendeten Daten lesen, sondern die das Detektierplättchen auch programmieren können. Vor allem beim Programmieren des Detektierplättchens ist nämlich eine optimale Abstimmung zwischen dem Detektierplättchen und der Rahmenantenne bzw. dem Lesegerät erforderlich, weil für den Programmiervorgang ein maximaler Strom benötigt wird, um die Speicherzellen im Detektierplättchen entsprechend zu verändern. Diesen maximalen Strom erhält man vorzugsweise dann, wenn die beiden Antennenschwingkreise des Detektierplättchens und des Lesegerätes gemeinsam auf die Resonanzfrequenz abgestimmt sind.

Die Realisierung des erfindungsgemäßen Gedankens der automatischen Abstimmung ist im übrigen unabhängig davon, ob der Antennenschwingkreis des Lesegerätes als Serien-Schwingkreis oder Parallel-Schwingkreis ausgebildet ist.

## Patentansprüche

1. Lesegerät (12) für ein Detektierplättchen (10), wobei das Lesegerät (12) einen Antennenschwingkreis (28) besitzt, der als Antenne (14) ausgebildet ist und einen Schwingkreiskondensator (C4) umfaßt, wobei das Detektierplättchen (10) einen Schwingkreis (C1, L1) mit einer vorgegebenen Resonanzfrequenz (fo) aufweist, und wobei der Antennenschwingkreis (28) des Lesegerätes (12) entsprechend dieser Resonanzfrequenz (fo) dimensioniert ist, **dadurch gekennzeichnet,** daß eine automatisch arbeitende Abstimmeinheit (22) vorgesehen ist, durch welche der Antennenschwingkreis (28) automatisch auf die vorgegebene Resonanzfrequenz (fo) abstimmbar ist, so daß auf den Antennenschwingkreis (28) einwirkende äußere Einflüsse, welche eine Abweichung der Resonanzfrequenz des Antennenschwingkreises (28) von der vorgegebenen Resonanzfrequenz (fo) bewirken, automatisch kompensiert werden.

2. Lesegerät nach Anspruch 1, **dadurch gekennzeichnet,** daß dem Antennenschwingkreis (28) durch die Abstimmeinheit (22) zusätzlich vorgesehene Kapazitäten (C5 -C8) und/oder Induktivitäten zuschaltbar sind, bzw. daß die zusätzlich vorgesehenen Kapazitäten und/oder Induktivitäten von dem Antennenschwingkreis (28) abschaltbar sind.

3. Lesegerät nach Anspruch 1 und/oder 2, **dadurch gekennzeichnet,** daß die Kapazität des Schwingkreiskondensators (C4) des Antennenschwingkreises (28) kleiner ist, als die der Resonanzfrequenz (fo) des Antennenschwingkreises (28) entsprechende Kapazität.

4. Lesegerät nach Anspruch 1 und/oder 2, **dadurch gekennzeichnet,** daß die Induktivität des Antennenschwingkreises (28) kleiner ist, als die der Resonanzfrequenz (fo) des Antennenschwingkreises (28) entsprechende Induktivität.

5. Lesegerät nach einem oder mehreren der vorhergehenden Ansprüche 2 - 4, **dadurch gekennzeichnet,** daß die Werte der zusätzlichen Kapazitäten und/oder Induktivitäten binär abgestuft sind.

6. Lesegerät nach einem oder mehreren der vorhergehenden Ansprüche 1 - 5, **dadurch gekennzeichnet,** daß das Lesegerät (12) in an sich bekannter Weise eine Auswerteeinheit (16) mit einem Mikroprozessor (26) umfaßt, und daß der Mikroprozessor (26) neben der üblichen Datenauswertung zur automatischen Abstimmung des Antennenschwingkreises (28) herangezogen wird.

7. Lesegerät nach einem oder mehreren der vorhergehenden Ansprüche 1 - 5, **dadurch gekennzeichnet,** daß die automatische Abstimmeinheit (22) einen separaten Abstimm-Mikroprozessor (24) umfaßt.

8. Lesegerät nach Anspruch 6 und/oder 7, **dadurch gekennzeichnet,** daß die Mikroprozessoren (24; 26) mit einem Algorithmus programmiert sind, der eine automatische Abstimmung des Antennenschwingkreises (28) auf seine Resonanzfrequenz (fo) ermöglicht.

9. Lesegerät nach Anspruch 8, **dadurch gekennzeichnet**, daß als Algorithmus für die automatische Abstimmung des Antennenschwingkreises (28) auf seine Resonanzfrequenz (fo) das Auffinden des Maximums der Schwingkreispannung bzw. des Schwingkreisstromes nach der Methode der sukzessiven Approximation angewandt wird.

10. Lesegerät nach einem der Ansprüche 7 - 9, **dadurch gekennzeichnet,** daß der separate Mikroprozessor (24) der Abstimmeinheit (22) ständig betriebsbereit und ständig eine automatische Abstimmung des Antennenschwingkreises (28) auf die Resonanzfrequenz (fo) durchführt.

11. Lesegerät nach einem oder mehreren der vorhergehenden Ansprüche 1 - 9, **dadurch gekennzeichnet,** daß die automatische Abstimmung nur innerhalb eines eingeschränkten wählbaren Abstimmbereiches erfolgt.

12. Lesegerät nach einem oder mehreren der vorhergehenden Ansprüche 1 - 11, **dadurch gekennzeichnet**, daß die automatische Abstimmung jeweils nach dem Einschalten der Betriebsspannung (UB) ("Power-On-Reset") vorgenommen wird.

13. Lesegerät nach einem oder mehreren der vorhergehenden Ansprüche 1 - 11, **dadurch gekennzeichnet**, daß die automatische Abstimmung durch ein von dem Detektierplättchen (10) gesendetes spezielles Schaltsignal eingeleitet wird.

14. Lesegerät nach einem oder mehreren der vorhergehenden Ansprüche 1 - 11, **dadurch gekennzeichnet,** daß die automatische Abstimmung in wählbaren Zeitabständen periodisch durchgeführt wird.

15. Lesegerät nach einem oder mehreren der vorhergehenden Ansprüche 1 - 11, **dadurch gekennzeichnet,** daß die automatische Abstimmung in Abhängigkeit der Qualität der vom Lesegerät (12) empfangenen Signale bei schlechter Signalform der Daten eingeleitet wird.

16. Lesegerät nach einem oder mehreren der vorhergehenden Ansprüche 1 - 15, **dadurch gekennzeichnet,** daß der Antennenschwingkreis (28) als Parallelschwingkreis ausgebildet ist.

17. Lesegerät nach einem oder mehreren der vorhergehenden Ansprüche 1 - 15, **dadurch gekennzeichnet,** daß der Antennenschwingkreis als Reihenschwingkreis ausgebildet ist.

## Claims

1. Reader (12) for an electronic ID tag (10), whereby the reader (12) has an antenna resonant circuit (28) which is designed as an antenna (14) and includes a resonant circuit capacitor (C4), whereby the tag (10) has a resonant circuit (C1, L1) with a pre-set resonant frequency (fo), and whereby the antenna resonant circuit (28) of the reader (12) is dimensioned according to this resonant frequency (fo), characterised in that an automatic tuning unit (22) is provided, by means of which the antenna resonant circuit (28) can be automatically tuned to the pre-set resonant frequency (fo) so that external influences affecting the antenna resonant circuit (28), which cause the resonant frequency of the antenna resonant circuit (28) to deviate from the pre-set resonant frequency (fo), are automatically compensated for.

2. Reader according to Claim 1, characterised in that additionally provided capacitances (C5 - C8) and/or inductances can be connected to the antenna resonant circuit (28) via the tuning unit (22) or that the additionally provided capacitances and/or inductances can be disabled by the antenna resonant circuit (28).

3. Reader according to Claim 1 and/or 2, characterised in that the capacitance of the resonant circuit capacitor (C4) of the antenna resonant circuit (28) is smaller than the capacitance corresponding to the resonance frequency (fo) of the antenna resonant circuit (28).

4. Reader according to Claim 1 and/or 2, characterised in that the inductance of the antenna resonant circuit (28) is smaller than the inductance corresponding to the resonance frequency (fo) of the antenna resonant circuit (28).

5. Reader according to one or more of the preceding Claims 2 - 4, characterised in that the values of the additional capacitances and/or inductances are stepped in a binary fashion.

6. Reader according to one or more of the preceding Claims 1 - 5, characterised in that the reader (12) includes, in a known fashion, an evaluation unit (16) with a microprocessor (26) and in that the microprocessor (26), alongside the usual data evaluation, is used for automatically tuning the antenna resonant circuit (28).

7. Reader according to one or more of the preceding Claims 1 - 5, characterised in that the automatic tuning unit (22) includes a separate tuning microprocessor (24).

8. Reader according to Claim 6 and/or 7, characterised in that the microprocessors (24; 26) are programmed with an algorithm which enables automatic tuning of the antenna resonant circuit (28) to its resonant frequency (fo).

9. Reader according to Claim 8, characterised in that the determined maximum for the resonant circuit voltage or the resonant circuit current according to the method of successive approximation is applied as algorithm for the automatic tuning of the antenna resonant circuit (28) to its resonant frequency (fo).

10. Reader according to one of Claims 7 - 9, characterised in that the separate microprocessor (24) of the tuning unit (22) is continuously operational and continuously carries out an automatic tuning of the antenna resonant circuit (28) to the resonant frequency (fo).

11. Reader according to one or more of the preceding Claims 1 - 9, characterised in that automatic tuning takes place only within a restricted, selectable tuning range.

12. Reader according to one or more of the preceding Claims 1 - 11, characterised in that automatic tuning is always carried out after power-on reset.

13. Reader according to one or more of the preceding Claims 1 - 11, characterised in that automatic tuning is initiated by a special switching signal sent from the tag (10).

14. Reader according to one or more of the preceding Claims 1 - 11, characterised in that automatic tuning is carried out periodically at selectable time intervals.

15. Reader according to one or more of the preceding Claims 1 - 11, characterised in that the initiation of automatic tuning depends on the quality of the signals received by the reader (12), automatic tuning being initiated where the signal shape of the data is poor.

16. Reader according to one or more of the preceding Claims 1 - 15, characterised in that the antenna resonant circuit (28) is designed as a parallel resonant circuit.

17. Reader according to one or more of the preceding Claims 1 - 15, characterised in that the antenna resonant circuit is designed as a series resonant circuit.

## Revendications

1. Lecteur (12) pour une plaquette de détection (10), le lecteur (12) comportant un circuit oscillant d'antenne (28) qui est constitué d'une antenne (14) et qui comporte un condensateur de circuit oscillant (C4), la plaquette de détection (10) comprenant un circuit oscillant (C1, L1) ayant une fréquence de résonance prédéfinie (fo). et le circuit oscillant d'antenne (28) du lecteur (12) étant dimensionné conformément à cette fréquence de résonance (fo), caractérisé en ce qu'il est prévu une unité d'accord (22) par laquelle le circuit oscillant d'antenne (28) peut être automatiquement réglé sur la fréquence de résonance (fo) de façon à compenser automatiquement les influences externes qui agissent sur le circuit oscillant d'antenne (28) et qui provoquent un glissement de la fréquence de résonance de ce circuit oscillant d'antenne (28) par rapport à la fréquence de résonance (fo).

2. Lecteur suivant la revendication 1, caractérisé en ce qu'au circuit oscillant d'antenne (28), peuvent être, par l'unité d'accord (22), raccordées des condensateurs (C5 à C8) et/ou des inductances prévues en supplément, ou en ce que des condensateurs et/ou des inductances prévues sont déconnectées du circuit oscillant d'antenne (28).

3. Lecteur suivant la revendication 1 et/ou 2, caractérisé en ce que la capacité du condensateur de circuit oscillant (C4) du circuit oscillant d'antenne (28) est plus faible que la capacité correspondant à la fréquence de résonance (fo) du circuit oscillant d'antenne (28).

4. Lecteur suivant la revendication 1 et/ou 2, caractérisé en ce que l'inductance du circuit oscillant d'antenne (28) est plus faible que l'inductance correspondant à la fréquence de résonance (fo) du circuit oscillant d'antenne (28).

5. Lecteur suivant une ou plusieurs des revendications précédentes 2 à 4, caractérisé en ce que les valeurs des condensateurs et/ou inductances supplémentaires sont échelonnées d'une manière binaire.

6. Lecteur suivant une ou plusieurs des revendications précédentes 1 à 5, caractérisé en ce que le lecteur (12) comporte, d'une manière connue en soi, une unité d'évaluation (16) avec un microprocesseur (26), et en ce que le microprocesseur (26 est amené près dé l'évaluation normale de données pour l'accord automatique du circuit oscillant d'antenne (28).

7. Lecteur suivant une ou plusieurs des revendications précédentes 1 à 5, caractérisé en ce que l'unité d'accord automatique (22) comporte un microprocesseur d'accord séparé (24).

8. Lecteur suivant la revendication 6 et/ou 7, caractérisé en ce que les microprocesseurs (24; 26) sont programmés avec un algorithme qui permet un accord automatique du circuit oscillant d'antenne (28) sur sa fréquence de résonance (fo).

9. Lecteur suivant la revendication 8, caractérisé en ce que, comme algorithme pour l'accord automatique du circuit oscillant d'antenne (28) sur sa fréquence de résonance (fo), est utilisée la détection du maximum de tension de circuit oscillant ou du courant de circuit oscillant suivant la méthode des approximations successives.

10. Lecteur suivant une des revendications 7 à 9, caractérisé en ce que le microprocesseur séparé (24) de l'unité d'accord (22) est constamment en ordre de marche et effectue en permanence un accord automatique du circuit oscillant d'antenne (28) sur la fréquence de résonance (fo).

11. Lecteur suivant une ou plusieurs des revendications précédentes 1 à 9, caractérisé en ce que l'accord automatique n'a lieu qu'à l'intérieur d'une zone d'accord limitée arbitraire.

12. Lecteur suivant une ou plusieurs des revendications précédentes 1 à 11, caractérisé en ce que l'accord automatique est exécuté à chaque fois après la mise en marche de la tension de service (UB) ("Power-On-Reset").

13. Lecteur suivant une ou plusieurs des revendications précédentes 1 à 11, caractérisé en ce que l'accord automatique est envoyé par l'intermédiaire d'un signal de commutation spécial lancé du lecteur (10).

14. Lecteur suivant une ou plusieurs des revendications précédentes 1 à 11, caractérisé en ce que l'accord automatique est effectué périodiquement à intervalles de temps arbitraires.

15. Lecteur suivant une ou plusieurs des revendications précédentes 1 à 11, caractérisé en ce que l'accord automatique est envoyé suivant la qualité des signaux reçus du lecteur (12) concernant la forme de signal mauvaise des données.

16. Lecteur suivant une ou plusieurs des revendications précédentes 1 à 15, caractérisé en ce que le circuit oscillant d'antenne (28) est un circuit oscillant parallèle.

17. Lecteur suivant une ou plusieurs des revendications précédentes 1 à 15, caractérisé en ce que le circuit oscillant d'antenne est un circuit oscillant série.
